(19) Europäisches Patentamt
European Patent Office
Office européen des brevets

(11) **EP 4 686 125 A1**

(12) **EUROPEAN PATENT APPLICATION**
published in accordance with Art. 153(4) EPC

(43) Date of publication:
**28.01.2026 Bulletin 2026/05**

(21) Application number: **23929487.9**

(22) Date of filing: **31.03.2023**

(51) International Patent Classification (IPC):
**H04L 1/22** (2006.01)    **H03M 13/25** (2006.01)

(52) Cooperative Patent Classification (CPC):
**H03M 13/25; H04L 1/22**

(86) International application number:
**PCT/CN2023/085713**

(87) International publication number:
**WO 2024/197904 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
• **WANG, Xianbin**
  **Shenzhen, Guangdong 518129 (CN)**
• **ZHANG, Huazi**
  **Shenzhen, Guangdong 518129 (CN)**
• **TONG, Jiajie**
  **Shenzhen, Guangdong 518129 (CN)**
• **WANG, Jun**
  **Shenzhen, Guangdong 518129 (CN)**

(74) Representative: **Isarpatent
Patent- und Rechtsanwälte Partg mbB
Friedrichstraße 31
80801 München (DE)**

(54) **DATA PROCESSING METHOD AND RELATED DEVICE**

(57) A data processing method is provided. The method may be applied to the field of communication technologies, and the method includes: generating a check block, where the check block is determined based on first bit sequences respectively corresponding to a plurality of code blocks, the first bit sequence is a part of a second bit sequence, and the second bit sequence is an encoded bit sequence of the code block corresponding to the first bit sequence; and sending the check block and the code blocks. In this way, error correction performance is improved when assisting in code block recovery.

Generate a check block, where the check block is determined based on first bit sequences respectively corresponding to a plurality of code blocks, the first bit sequence is a part of a second bit sequence, and the second bit sequence is an encoded bit sequence of the code block corresponding to the first bit sequence — S1

Send the check block and the code blocks — S2

FIG. 1b

**Description**

<u>TECHNICAL FIELD</u>

This application relates to the field of communication technologies, and in particular, to a data processing method and a related apparatus.

<u>BACKGROUND</u>

Different service scenarios, such as ultra-reliable and low-latency communications, enhanced mobile broadband communication, and massive machine learning communication, have different requirements on reliability, a latency, and the like of data transmission. In a process of service data transmission, an error may occur in data transmission, especially when transmission of a plurality of services is performed at the same time. How to recover erroneous data is one of technical problems that need to be resolved in a communication system currently.

<u>SUMMARY</u>

This application provides a data processing method and a related apparatus, to improve error correction performance when assisting in code block recovery.

According to a first aspect, this application provides a data processing method. The method may be applied to the field of communication technologies. In the method, the following steps are performed.

First, a check block is generated. The check block is determined based on first bit sequences respectively corresponding to a plurality of code blocks, the first bit sequence is a part of a second bit sequence, and the second bit sequence is an encoded bit sequence of the code block corresponding to the first bit sequence. Then, the check block and the code blocks are sent.

Compared with directly generating the check block based on second bit sequences respectively corresponding to the plurality of code blocks, in this application, the first bit sequences are determined from encoded bit sequences corresponding to the plurality of code blocks, and the check block is determined based on the first bit sequences. In this way, when an error occurs in one or more code blocks, erroneous data can be recovered based on the generated check block, so that error correction performance can be improved when assisting in code block recovery. In addition, a requirement for performing retransmission of data by using a hybrid automatic repeat request mechanism is omitted, so that a data transmission latency is further reduced.

In a possible implementation of the first aspect, the first bit sequences respectively corresponding to the plurality of code blocks include redundancy version sequences respectively corresponding to the code blocks.

In this implementation, the check block is generated by using the redundancy version sequences respectively corresponding to the code blocks, so that when an error occurs in the plurality of code blocks, at least one code block in which the error occurs can be recovered by using the redundancy version sequence.

In a possible implementation of the first aspect, the plurality of code blocks correspond to a first communication mode.

In this implementation, this application supports a data transmission requirement of the first communication mode.

In a possible implementation of the first aspect, a time-frequency resource for transmission in the first communication mode is partially occupied by transmission in a second communication mode, where the first communication mode and the second communication mode correspond to different services.

In this implementation, transmission requirements of both the first communication mode and the second communication mode are supported. The time-frequency resource for transmission in the first communication mode is partially occupied by transmission in the second communication mode, to meet the transmission requirement of the second communication mode.

In a possible implementation of the first aspect, a size of the check block is determined based on at least one of the following:

a code length and/or a code rate corresponding to transmission in the first communication mode, and a code length and/or a code rate corresponding to transmission in the second communication mode.

In this implementation, transmission parameters of both the first communication mode and the second communication mode are combined, where the transmission parameters specifically include the code lengths, the code rates, and the like, to meet transmission requirements of both the first communication mode and the second communication mode.

In a possible implementation of the first aspect, the first communication mode is enhanced mobile broadband eMBB, and the second communication mode is ultra-reliable and low-latency communications urLLC.

In this implementation, when the first communication mode is eMBB and the second communication mode is urLLC, because a data packet of a urLLC service is generated in a bursty and random manner, a part of allocated time-frequency resources used to perform transmission of eMBB service data are selected to perform transmission of urLLC service data, to meet an ultra-low-latency requirement of the urLLC service.

In a possible implementation of the first aspect, the first communication mode is ultra-reliable and low-latency communications urLLC.

When a sending device transmits only a urLLC service, due to a latency limitation, a urLLC code length is small, and it is generally difficult to meet a reliability requirement of urLLC in a case of a short code. In this case, in a current standard, the reliability requirement is generally met by reducing a code rate and using HARQ retransmission. This results in a low urLLC transmission rate and an increased latency. In this implementation, for a scenario of transmission of only the urLLC service, the check block is generated by using the redundancy version sequence of the code block, so that data can still be recovered based on the check block when an error like a transmission failure occurs in a CB of urLLC. This omits a HARQ requirement and further reduces a transmission latency.

In a possible implementation of the first aspect, before generating the check block, the method includes: obtaining indication information, where the indication information indicates the plurality of code blocks that participate in generating the check block, and the plurality of code blocks belong to a first code block group.

In this implementation, the plurality of code blocks that participate in generating the check block can be flexibly selected based on the indication information. This further improves data transmission flexibility.

In a possible implementation of the first aspect, generating the check block specifically includes:

first obtaining positions of the first bit sequences respectively corresponding to the plurality of code blocks, where the position is a position of the first bit sequence in the second bit sequence;
then obtaining lengths of the first bit sequences respectively corresponding to the plurality of code blocks;
then determining, based on the positions and the lengths of the first bit sequences respectively corresponding to the plurality of code blocks, a third bit sequence corresponding to the plurality of code blocks; and
finally generating the check block based on the third bit sequence corresponding to the plurality of code blocks.

In this implementation, the positions of the first bit sequences are determined from the second bit sequences respectively corresponding to the plurality of code blocks, and the check block is finally generated with reference to the lengths of the first bit sequences. Compared with directly generating the check block based on the second bit sequences respectively corresponding to the plurality of code blocks, in this application, when an error occurs in at least one of the plurality of code blocks, erroneous data can be recovered based on the check block, so that error correction performance is improved when assisting in code block recovery, and a data transmission latency can be further reduced.

In a possible implementation of the first aspect, generating the check block includes:

encoding the plurality of code blocks based on a coding matrix, to obtain a fourth bit sequence; and
generating the check block based on the fourth bit sequence.

In this implementation, the check block may be generated based on the coding matrix by using a plurality of encoding manners, and a proper coding matrix is selected, to improve error correction performance to some extent when assisting in code block recovery, and increase a decoding success probability.

According to a second aspect, this application provides a data processing method. The method may be applied to the field of communication technologies, and the method specifically includes: first, receiving first information, where the first information includes check block information and code block information, a check block is determined based on first bit sequences respectively corresponding to a plurality of code blocks, the first bit sequence is a part of a second bit sequence, and the second bit sequence is an encoded bit sequence of the code block corresponding to the second bit sequence; and then decoding the first information to obtain decoded data.

In this application, the first information from a transmit end is received and decoded, so that when it is determined that erroneous data exists in the decoded data, the erroneous data can be recovered based on decoded check block information and decoded code block information, thereby improving error correction performance when assisting in code block recovery.

In a possible implementation of the second aspect, the first bit sequences respectively corresponding to the plurality of code blocks include redundancy version sequences respectively corresponding to the code blocks.

In a possible implementation of the second aspect, the plurality of code blocks correspond to a first communication mode.

In a possible implementation of the second aspect, a time-frequency resource for transmission in the first communication mode is partially occupied by transmission in a second communication mode, where the first communication mode and the second communication mode correspond to different services.

In a possible implementation of the second aspect, a size of the check block is determined based on at least one of the following:
a code length and/or a code rate corresponding to transmission in the first communication mode, and a code length and/or a code rate corresponding to transmission in the second communication mode.

In a possible implementation of the second aspect, the first communication mode is enhanced mobile broadband eMBB, and the second communication mode is ultra-reliable and low-latency communications urLLC.

In a possible implementation of the second aspect, the first communication mode is ultra-reliable and low-latency communications urLLC.

For specific meanings of terms in the second aspect and the possible implementations of the second aspect in embodiments of this application, refer to descriptions in the possible implementations of the first aspect. Details are not described herein again.

According to a third aspect, this application provides a sending device. For beneficial effects, refer to the descriptions of the first aspect. Details are not described herein again. The sending device has a function of implementing behavior in the method embodiment of the first aspect. The function may be implemented by hardware, or may be implemented by executing corresponding software by hardware. The hardware or software includes one or more modules corresponding to the foregoing function. In a possible design, the sending device includes:

a processing unit, configured to generate a check block, where the check block is determined based on first bit sequences respectively corresponding to a plurality of code blocks, the first bit sequence is a part of a second bit sequence, and the second bit sequence is an encoded bit sequence of the code block corresponding to the first bit sequence; and
a sending unit, configured to send the check block and the code blocks.

The processing unit and the sending unit may perform corresponding functions in the method example in the first aspect. For details, refer to the detailed descriptions in the method example. Details are not described herein again.

In a possible implementation of the third aspect, the first bit sequences respectively corresponding to the plurality of code blocks include redundancy version sequences respectively corresponding to the code blocks.

In a possible implementation of the third aspect, the plurality of code blocks correspond to a first communication mode.

In a possible implementation of the third aspect, a time-frequency resource for transmission in the first communication mode is partially occupied by transmission in a second communication mode, where the first communication mode and the second communication mode correspond to different services.

In a possible implementation of the third aspect, a size of the check block is determined based on at least one of the following:
a code length and/or a code rate corresponding to transmission in the first communication mode, and a code length and/or a code rate corresponding to transmission in the second communication mode.

In a possible implementation of the third aspect, the first communication mode is enhanced mobile broadband eMBB, and the second communication mode is ultra-reliable and low-latency communications urLLC.

In a possible implementation of the third aspect, the first communication mode is ultra-reliable and low-latency communications urLLC.

In a possible implementation of the third aspect, before generating the check block, the processing unit is further configured to:
obtain indication information, where the indication information indicates the plurality of code blocks that participate in generating the check block, and the plurality of code blocks belong to a first code block group.

In a possible implementation of the third aspect, the processing unit is further configured to:

obtain positions of the first bit sequences respectively corresponding to the plurality of code blocks, where the position is a position of the first bit sequence in the second bit sequence;
obtain lengths of the first bit sequences respectively corresponding to the plurality of code blocks;
determine, based on the positions and the lengths of the first bit sequences respectively corresponding to the plurality of code blocks, a third bit sequence corresponding to the plurality of code blocks; and
generate the check block based on the third bit sequence corresponding to the plurality of code blocks.

In a possible implementation of the third aspect, the processing unit is further configured to:

encode the plurality of code blocks based on a coding matrix, to obtain a fourth bit sequence; and
generate the check block based on the fourth bit sequence.

According to a fourth aspect, this application provides a receiving device. For beneficial effects, refer to the descriptions of the second aspect. Details are not described herein again. The receiving device has a function of implementing behavior in the method embodiment of the second aspect. The function may be implemented by hardware, or may be implemented by executing corresponding software by hardware. The hardware or software includes one or more modules corresponding to the foregoing function. In a possible design, the receiving device includes:

a receiving unit, configured to receive first information, where the first information includes check block information and code block information, a check block is determined based on first bit sequences respectively corresponding to a plurality of code blocks, the first bit sequence is a part of a second bit sequence, and the second bit sequence is an encoded bit sequence of the code block corresponding to the first bit sequence; and
a processing unit, configured to decode the first information to obtain decoded data.

The receiving unit and the processing unit may perform corresponding functions in the method example in the second aspect. For details, refer to the detailed descriptions in the method example. Details are not described herein again.

In a possible implementation of the fourth aspect, the first bit sequences respectively corresponding to the plurality of code blocks include redundancy version sequences respectively corresponding to the code blocks.

In a possible implementation of the fourth aspect, the plurality of code blocks correspond to a first communication mode.

In a possible implementation of the fourth aspect, a time-frequency resource for transmission in the first communication mode is partially occupied by transmission in a second communication mode, where the first communication mode and the second communication mode correspond to different services.

In a possible implementation of the fourth aspect, a size of the check block is determined based on at least one of the following:

a code length and/or a code rate corresponding to transmission in the first communication mode, and a code length and/or a code rate corresponding to transmission in the second communication mode.

In a possible implementation of the fourth aspect, the first communication mode is enhanced mobile broadband eMBB, and the second communication mode is ultra-reliable and low-latency communications urLLC.

In a possible implementation of the fourth aspect, the first communication mode is ultra-reliable and low-latency communications urLLC.

According to a fifth aspect, this application provides a communication device, including a processor and an interface circuit. The interface circuit is configured to: receive a signal from another communication device and transmit the signal to the processor, or send a signal from the processor to another communication device. The processor is configured to implement the method according to any one of the first aspect or the possible implementations of the first aspect by using a logic circuit or by executing code instructions.

According to a sixth aspect, this application provides a communication device, including a processor and an interface circuit. The interface circuit is configured to receive a signal from another communication device and transmit the signal to the processor, or send a signal from the processor to another communication device. The processor is configured to implement the method according to any one of the second aspect or the possible implementations of the second aspect by using a logic circuit or by executing code instructions.

According to a seventh aspect, this application provides a communication system. The communication system includes the communication device according to the fifth aspect and/or the communication device according to the sixth aspect.

According to an eighth aspect, this application provides a computer program product. When the computer product is executed by a computer, the method according to any one of the first aspect or the possible implementations of the first aspect is implemented, or the method according to any one of the second aspect or the possible implementations of the second aspect is implemented.

According to a ninth aspect, this application provides a computer-readable storage medium. The storage medium stores a computer program or instructions. When the computer program or the instructions are executed by a communication device, the method according to any one of the first aspect or the possible implementations of the first aspect is implemented, or the method according to any one of the second aspect or the possible implementations of the second aspect is implemented.

For technical effects brought by any one of the third aspect, the fifth aspect, the seventh aspect, the eighth aspect, and the ninth aspect, or the possible implementations thereof, refer to the technical effects brought by the first aspect or different possible implementations of the first aspect. Details are not described herein again.

For technical effects brought by any one of the fourth aspect, the sixth aspect, the seventh aspect, the eighth aspect, and the ninth aspect, or the possible implementations thereof, refer to the technical effects brought by the second aspect or different possible implementations of the second aspect. Details are not described herein again.

**BRIEF DESCRIPTION OF DRAWINGS**

FIG. 1a is a diagram of an architecture of a communication system to which an embodiment of this application is applied;

FIG. 1b is a schematic flowchart of data processing according to an embodiment of this application;

FIG. 2a is a diagram in which urLLC service data preempts a time-frequency resource used to perform transmission of eMBB service data according to an embodiment of this application;

FIG. 2b is a schematic flowchart of wireless communication according to an embodiment of this application;

FIG. 3 is a diagram of a currently used data processing method;

FIG. 4 is another schematic flowchart of a data processing method according to an embodiment of this application;

FIG. 5 is a diagram of code block grouping according to an embodiment of this application;

FIG. 6 is a diagram of position distribution of a first bit sequence and a second bit sequence according to an embodiment of this application;

FIG. 7a is a diagram of generating third bit sequences according to an embodiment of this application;

FIG. 7b is a diagram of generating a check block according to an embodiment of this application;

FIG. 8 is a diagram of decoding by a receiving device according to an embodiment of this application;

FIG. 9 is another schematic flowchart of a data processing method according to an embodiment of this application;

FIG. 10 is a diagram of a structure of a sending device according to an embodiment of this application;

FIG. 11 is a diagram of a structure of a receiving device according to an embodiment of this application;

FIG. 12 is a diagram of a structure of a communication device according to an embodiment of this application; and

FIG. 13 is a diagram of another structure of a communication device according to an embodiment of this application.

**DESCRIPTION OF EMBODIMENTS**

The following clearly and completely describes the technical solutions in embodiments of this application with reference to the accompanying drawings in embodiments of this application.

The following clearly and completely describes the technical solutions in embodiments of this application with reference to the accompanying drawings in embodiments of this application. It is clear that the described embodiments are merely a part rather than all of embodiments of this application. All other embodiments obtained by a person skilled in the art based on embodiments of this application without creative efforts shall fall within the protection scope of this application. A person skilled in the art may learn that, as technologies develop and a new scenario emerges, the technical solutions provided in embodiments of this application are also applicable to resolve a similar technical problem.

In the specification, claims, and accompanying drawings of this application, the terms "first", "second", and so on are intended to distinguish between similar objects but do not necessarily indicate a specific order or sequence. It should be understood that the data termed in such a way are interchangeable in proper circumstances so that embodiments described herein can be implemented in other orders than the order illustrated or described herein. Moreover, the terms "include", "contain" and any other variants mean to cover the non-exclusive inclusion, for example, a process, method, system, product, or device that includes a list of steps or modules is not necessarily limited to those steps or modules, but may include other steps or modules not expressly listed or inherent to such a process, method, system, product, or device.

The term "and/or" in this application describes only an association relationship for describing associated objects and represents that three relationships may exist. For example, A and/or B may represent the following three cases: Only A exists, both A and B exist, and only B exists. In addition, the character "/" in this application generally indicates an "or" relationship between the associated objects.

It should also be noted that in some alternative implementations, the specified functions/actions may not appear in orders of the accompanying drawings. For example, actually, two accompanying drawings shown in succession may essentially occur at the same time or may sometimes be performed in a reverse order, depending on the related functions/actions.

In embodiments of this application, unless otherwise specified, "at least one" means one or more, and "a plurality of" means two or more. It may be understood that, in this application, "when", "provided", and "if" all mean that an apparatus performs corresponding processing in an objective case, and are not intended to limit time, and do not mean that the apparatus is required to have a determining action during implementation, and do not mean any other limitation. In addition, the specific term "example" means "used as an example, embodiment, or illustration". Any embodiment described as an "example" is not necessarily explained as being superior or better than other embodiments.

The following describes embodiments of this application with reference to the accompanying drawings. A person of ordinary skill in the art may learn that, as technologies develop and a new scenario emerges, the technical solutions provided in embodiments of this application are also applicable to resolve a similar technical problem.

First, to better understand the solutions in embodiments of this application, the following first describes an application scenario of embodiments of this application.

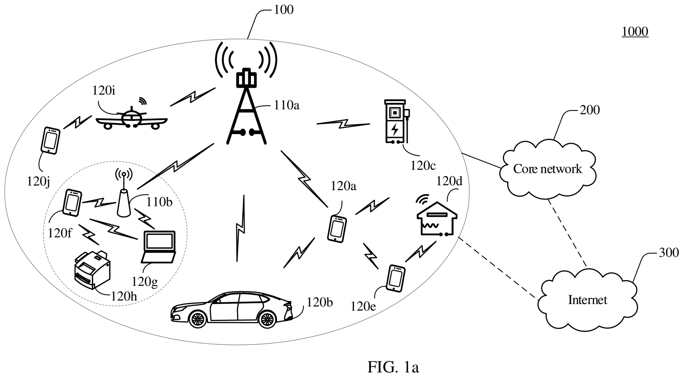

FIG. 1a is a diagram of an architecture of a communication system to which an embodiment of this application is applied. As shown in FIG. 1a, the communication system 1000 includes a radio access network 100 and a core network 200. Optionally, the communication system 1000 may further include an internet 300. The radio access network 100 may include at least one network device (for example, 110a and 110b in FIG. 1a), and may further include at least one terminal device (for example, 120a to 120j in FIG. 1a). The terminal device is connected to the network device in a wireless manner, and the network device is connected to the core network in a wireless or wired manner. The core network device and the network device may be different physical devices independent of each other, or functions of the core network device and logical functions of the network device may be integrated into a same physical device, or some functions of the core network device and some functions of the network device may be integrated into one physical device. Terminal devices may be connected to each other and network devices may be connected to each other in a wired or wireless manner. FIG. 1a is merely a diagram. The communication system may further include other network devices, for example, may further include a wireless relay device and a wireless backhaul device, which are not shown in FIG. 1a.

The network device is an access device that is used by the terminal device to access the communication system in a wireless manner. The network device may be a base station (base station), an evolved NodeB (evolved NodeB, eNodeB), a transmission reception point (transmission reception point, TRP), a next generation NodeB (next generation NodeB, gNB) in a $5^{th}$ generation ($5^{th}$ generation, 5G) mobile communication system, a next generation base station in a $6^{th}$ generation ($6^{th}$ generation, 6G) mobile communication system, a base station in a future mobile communication system, an access node in a Wi-Fi system, or the like, or may be a module or a unit that completes a part of functions of the base station, for example, may be a central unit (central unit, CU), or may be a distributed unit (distributed unit, DU). The CU herein completes functions of a radio resource control protocol and a packet data convergence protocol (packet data convergence protocol, PDCP) of the base station, and may further complete a function of a service data adaptation protocol (service data adaptation protocol, SDAP). The DU completes functions of a radio link control layer and a medium access control (medium access control, MAC) layer of the base station, and may further complete a part or all of functions of a physical layer. For detailed descriptions of the foregoing protocol layers, refer to related technical specifications of the $3^{rd}$ generation partnership project ($3^{rd}$ generation partnership project, 3GPP). The network device may be a macro base station (for example, 110a in FIG. 1a), may be a micro base station or an indoor base station (for example, 110b in FIG. 1a), or may be a relay node, a donor node, or the like. A specific technology and a specific device form that are used by the network device are not limited in embodiments of this application. The following uses a base station as an example for description.

The terminal device is a device that has a wireless transceiver function, and may send a signal to the network device, or receive a signal from the network device. The terminal device may also be referred to as user equipment (user equipment, UE), a mobile station, a mobile terminal, or the like. The terminal device may be widely used in various scenarios, for example, device-to-device (device-to-device, D2D), vehicle to everything (vehicle to everything, V2X) communication, machine-type communication (machine-type communication, MTC), internet of things (internet of things, IOT), virtual reality, augmented reality, industrial control, self-driving, telemedicine, smart grid, smart furniture, smart office, smart wearable, smart transportation, and smart city. The terminal device may be a mobile phone, a tablet computer (Pad), a computer having a wireless transceiver function, a wearable device, a vehicle, a vehicle-mounted mobile apparatus, an airplane, a ship, a robot, a robot arm, a personal digital assistant, a wearable device, a virtual reality (virtual reality, VR) device, an augmented reality (augmented reality, AR) device, various internet of things devices, or the like. A specific technology and a specific device form that are used by the terminal device are not limited in embodiments of this application.

The network device and the terminal device may be at fixed locations, or may be movable. The network device and the terminal device may be deployed on land, including being deployed indoors or outdoors, or in a handheld manner or a vehicle-mounted manner; may be deployed on water; or may be deployed on an airplane, a balloon, and an artificial satellite. Application scenarios of the network device and the terminal device are not limited in embodiments of this application.

Roles of the network device and the terminal device may be relative. For example, the helicopter or uncrewed aerial vehicle 120i in FIG. 1a may be configured as a mobile network device. For the terminal device 120j that accesses the radio access network 100 via 120i, the terminal device 120i is a network device. However, for the network device 110a, 120i is a terminal device, to be specific, 110a and 120i communicate with each other by using a radio air interface protocol. Certainly, 110a and 120i may alternatively communicate with each other by using an interface protocol between network devices. In this case, relative to 110a, 120i is also a network device. Therefore, both the network device and the terminal device may be collectively referred to as communication devices. 110a and 110b in FIG. 1a may be referred to as communication devices having a function of a network device, and 120a to 120j in FIG. 1a may be referred to as communication devices having a function of a terminal.

Communication between a network device and a terminal device, between network devices, or between terminal devices may be performed by using a licensed spectrum, an unlicensed spectrum, or both a licensed spectrum and an unlicensed spectrum; and may be performed by using a spectrum below 6 gigahertz (gigahertz, GHz), a spectrum above 6 GHz, or both a spectrum below 6 GHz and a spectrum above 6 GHz. A spectrum resource used for wireless communication is not limited in embodiments of this application.

In embodiments of this application, the function of the network device may alternatively be performed by a module (for example, a chip) in the network device, or may be performed by a control subsystem having the function of the network device. The control subsystem having the function of the network device may be a control center in the foregoing application scenarios such as smart grid, industrial control, smart transportation, and smart city. The function of the terminal device may alternatively be performed by a module (for example, a chip or a modem) in the terminal device, or may be performed by an apparatus having the function of the terminal.

A data transmission method provided in embodiments of this application is applicable to downlink data transmission, uplink data transmission, and device-to-device (device-to-device, D2D) data transmission. For downlink data transmission, a sending device is a network device, and a corresponding receiving device is a terminal device. For uplink data transmission, a sending device is a terminal device, and a corresponding receiving device is a network device. For D2D data transmission, a sending device is a terminal device, and a corresponding receiving device is also a terminal device. An application scenario is not limited in embodiments of this application.

The data transmission method provided in embodiments of this application is applicable to a communication system using a hybrid automatic repeat request (Hybrid Automatic Repeat request, HARQ) technology, a frequency division duplex (Frequency Division Duplex, FDD) system, and a time division duplex (Time Division Duplex, TDD) system. The data transmission method provided in embodiments of this application is applicable to any communication system that uses a low-density parity-check (low density parity check, LDPC) code or a polar code (Polar code) as a data channel coding manner, or applicable to a 5G communication system and another wireless communication system. This is not limited in embodiments of this application.

Communication between the network device and the terminal device and communication between terminal devices may be performed by using a licensed spectrum (licensed spectrum), an unlicensed spectrum (unlicensed spectrum), or both a licensed spectrum and an unlicensed spectrum. Communication between the access network device and the terminal device and between the terminal devices may be performed by using a spectrum below 6G, a spectrum above 6G, or both a spectrum below 6G and a spectrum above 6G. A spectrum resource used between the network device and the terminal device is not limited in embodiments of this application.

It may be understood that the structure of the communication system shown in FIG. 1a is merely an example. The data processing method provided in embodiments of this application may be applied to, but is not limited to, the foregoing described structure. This is not limited herein.

The current communication system 1000 is used as an example. Currently, in a process of communication between devices in the communication system 1000, for a problem that an error occurs in data of which transmission is performed, a check block obtained by encoding a plurality of code blocks is generally used to recover, through reverse encoding, a code block in which an error occurs. However, the check block is generally obtained by directly encoding the plurality of code blocks, and is applicable only to a case in which an error occurs in one code block. When an error occurs in two or more code blocks, all the code blocks in which the error occurs cannot be obtained through reverse encoding by using the check block, and error correction performance is poor when assisting in code block recovery.

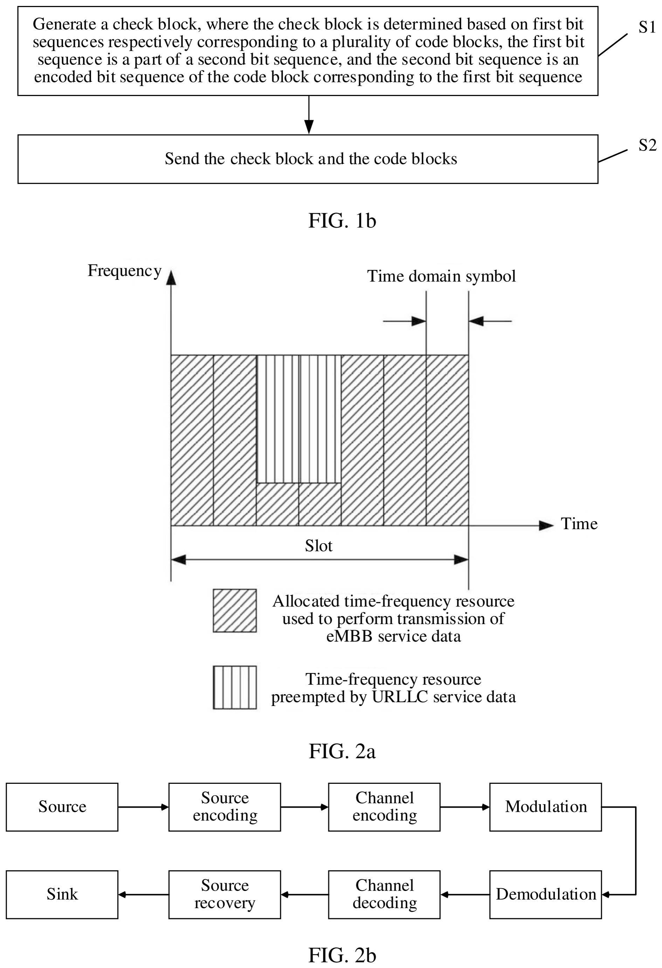

To resolve the foregoing problem, embodiments of this application provide a data processing method. The method is applied to the network device (110a and 110b) or the terminal device (120a to 120j) shown in FIG. 1a, or may be a chip, a chip system, a processor, or the like that supports the network device or the terminal device in implementing the foregoing method. For details, refer to FIG. 1b. FIG. 1b is a schematic flowchart of data processing according to an embodiment of this application. The method specifically includes the following steps. S1: Generate a check block, where the check block is determined based on first bit sequences respectively corresponding to a plurality of code blocks, the first bit sequence is a part of a second bit sequence, and the second bit sequence is an encoded bit sequence of the code block corresponding to the first bit sequence. S2: Send the check block and the code blocks. Compared with directly generating the check block based on second bit sequences respectively corresponding to the plurality of code blocks, in this application, the first bit sequences are determined from encoded bit sequences corresponding to the plurality of code blocks, and the check block is determined based on the first bit sequences. In this way, when an error occurs in at least one code block, erroneous data can be recovered based on the generated check block, so that error correction performance is improved when assisting in code block recovery. In addition, a requirement for performing retransmission of data by using a hybrid automatic repeat request mechanism is omitted, so that a data transmission latency is further reduced.

The foregoing describes a scenario to which the data processing method provided in embodiments of this application is applied. The following describes in detail an implementation process of the data processing method provided in embodiments of this application.

First, to better understand solutions in embodiments of this application, the following first describes related terms and concepts that may be used in embodiments of this application.

(1) Service scenario

Currently, three typical service scenarios are respectively enhanced mobile broadband (Enhanced Mobile Broadband, eMBB), ultra-reliable and low-latency (Ultra-Reliable and Low-Latency Communications, urLLC), and massive machine type communications (massive Machine Type, mMTC). A service scenario including the foregoing services or a similar service scenario may also be applicable to a future communication standard (for example, a 6G standard).

Typical eMBB services include ultra-high definition video, AR, VR, and the like. These services are mainly characterized by a large amount of data of which transmission is performed and a very high transmission rate. Typical urLLC services include tactile interaction applications such as wireless control in an industrial manufacturing or production process, motion control and remote repair of an uncrewed vehicle and an uncrewed aircraft, and remote surgery. These services are mainly characterized by ultra-high reliability, a low latency, a small amount of data of which transmission is performed, and burstiness. Typical mMTC services include smart grid distribution automation, smart cities, and the like. These services are mainly characterized by a huge quantity of network-connected devices, a small amount of data of which transmission is performed, and insensitivity of data to a transmission latency. These mMTC terminals need to meet requirements of low costs and extremely long standby duration.

Different services have different requirements on a communication system. How to better support all reliability requirements of data transmission of a plurality different services is one of technical problems that need to be resolved by the system currently. For example, how to support both the urLLC service and the eMBB service is one of hot topics discussed for a current mobile communication system.

A data packet of the urLLC service is generated in a bursty and random manner, and no data packet may be generated within a very long period of time, or a plurality of data packets may be generated within a very short period of time. A system resource is usually allocated by a base station. If the base station allocates a resource to the urLLC service in a manner of reserving the resource, the system resource is wasted when there is no urLLC service. In addition, a low-latency feature of the urLLC service requires that data packet transmission be completed within an extremely short period of time. Therefore, the base station needs to reserve sufficiently large bandwidth for the urLLC service, causing a severe decrease in system resource utilization.

Because the eMBB service has a large amount of data and a high transmission rate, a large time scheduling unit is usually used for data transmission to improve transmission efficiency. A small time scheduling unit is usually used for urLLC service data to meet an ultra-low-latency requirement.

Due to burstiness of the urLLC service data, to improve system resource utilization of the communication system, the base station usually reserves no resource for downlink data transmission of the urLLC service. When the urLLC service data arrives at the base station, if there is no idle time-frequency resource, to meet the ultra-low-latency requirement of the urLLC service, the base station cannot wait to schedule the urLLC service data after transmission of currently scheduled eMBB service data is completed. In this case, the base station may allocate the resource to the urLLC service data in a preemption (preemption) manner. Preemption herein means that the base station selects a part or all of allocated time-frequency resources used to perform transmission of the eMBB service data, to perform transmission of the urLLC service data, and the base station does not send the eMBB service data on the time-frequency resource used to perform transmission of the urLLC service data.

FIG. 2a is a diagram in which urLLC service data preempts a time-frequency resource used to perform transmission of eMBB service data according to an embodiment of this application. As shown in FIG. 2a, a horizontal axis represents time, and a vertical axis represents a frequency. In FIG. 2a, a shadow area with oblique lines represents an allocated time-frequency resource used to perform transmission of eMBB service data, and a shadow area with vertical lines represents a time-frequency resource preempted by urLLC service data. In other words, the urLLC service data preempts resources of a 3rd time domain symbol and a 4th time domain symbol in one slot. As shown in FIG. 2a, the time-frequency resource preempted by the urLLC service data is obtained by puncturing the time-frequency resource for the eMBB service data. Therefore, the time-frequency resource preempted by the urLLC service data is also referred to as a time-frequency resource at a punctured position.

In a scenario in which an eMBB service and a urLLC service coexist, a base station needs to notify a terminal device of the preempted time-frequency resource (also referred to as the time-frequency resource at the punctured position). During downlink data transmission, when a transport block (transport block, TB) is large, the base station divides the TB into a plurality of code blocks (code blocks, CBs), groups the plurality of CBs into a plurality of code block groups (code block groups, CBGs), and then maps each CBG to a time-frequency resource after encoding and modulation.

(2) Channel coding

Channel coding is a theory and a method that are implemented by using a channel encoder and a channel decoder to improve channel reliability. A main purpose of channel coding is to improve reliability of signal transmission and improve transmission quality of a communication system.

FIG. 2b is a schematic flowchart of wireless communication according to an embodiment of this application. At a transmit end, a source is sent after source encoding, channel encoding, and modulation are sequentially performed. At a receive end, a sink is output after demodulation, channel decoding, and source recovery are sequentially performed. For example, an LDPC code or a polar code may be used for channel encoding/decoding. At the transmit end, rate matching is performed after channel encoding, to achieve any target code length. At the receive end, de-rate matching is performed before channel decoding.

Several important parameters in channel coding are defined as follows:

A code length is a quantity of elements included in a code group.

A code rate is an averaged amount of information and carried in each element, and indicates a quantity of bits transmitted per unit time.

The code rate indicates utilization efficiency of a channel, and is an important parameter for measuring channel coding performance.

(3) Hybrid automatic repeat request technology

The hybrid automatic repeat request (Hybrid Automatic Repeat request, HARQ) technology is a technology combining forward error correction (Forward Error Correction, FEC) coding and an automatic repeat request (Automatic Repeat request, ARQ). A receiving device can correct a part of erroneous data by using the FEC technology. For an erroneous data packet that cannot be corrected, the receiving device requests a sending device to retransmit data of an original transport block (Transport Block, TB).

(4) Sequence

The sequence is a bit string including a bit "0" and/or a bit "1". A length of the sequence is a quantity of bits included in the sequence. For example, a sequence "00" includes two bits, and a length of the sequence "00" is 2. A sequence "111" includes three bits, and a length of the sequence "111" is 3. A sequence "0100" includes four bits, and a length of the sequence "0100" is 4.

The foregoing describes the terms provided in embodiments of this application. To better understand the technical solutions provided in embodiments of this application, the following describes a currently used data processing method.

urLLC has an extremely high requirement on a latency and an extremely strict requirement on an error probability. Therefore, it is a huge challenge to implement an efficient urLLC system. Two main aspects are as follows:

(1) A low-latency requirement brings a new challenge to a resource allocation policy of a current communication system.

In an eMBB scenario, transmission of a resource performed by a communication system is generally based on pre-scheduling. To be specific, a base station pre-allocates resources such as a slot and a subcarrier to different users, so that the users receive and send data. Generally, a urLLC service volume is far less than an eMBB service volume. Therefore, trigger time of a urLLC service requirement often occurs after allocation of an eMBB service resource is completed. In this case, if a scheduling process of a urLLC service is forcibly delayed until an eMBB service ends, extra latency overheads are introduced, and a low-latency requirement of urLLC cannot be met.

(2) High reliability and a low latency bring a new challenge to channel coding.

Channel coding is a general technology for improving reliability. To implement highly reliable transmission, an excellent channel coding technology is usually required. Due to a latency limitation, the urLLC service is usually sent with the arrival, and a data packet is not excessively long. Compared with a long packet, a short packet has a smaller coding gain, resulting in poor performance. In other words, a high transmission power or a high signal-to-noise ratio is required to reach a block error rate (block error rate, BLER) requirement of 1E-6. This also brings a great challenge to the communication system.

In a 5G standardization phase, the urLLC service is discussed and a series of technologies are standardized to attempt to address the foregoing two challenges.

For challenge (1), 5G NR allows urLLC to occupy a resource of eMBB. Specifically, when urLLC is triggered, a resource originally allocated to eMBB may be directly used by urLLC, so that a latency of urLLC is reduced.

For challenge (2), 5G NR uses a policy like HARQ enhancement. To be specific, HARQ enhancement introduces a fast acknowledgement (acknowledgement, ACK)/negative acknowledgement (negative acknowledgement, NACK) feedback for each small urLLC packet, so that a transmission latency is reduced. In addition, it should be noted that, NR does not perform a specific coding design for urLLC, but uses an eMBB coding design, and only a modulation and coding scheme (Modulation and scheme, MCS) table is redesigned to improve transmission reliability by reducing a transmission code rate.

In conclusion, the introduction of the urLLC service causes interference to the eMBB service, and a transmission rate of the urLLC service is very low, resulting in poor system performance.

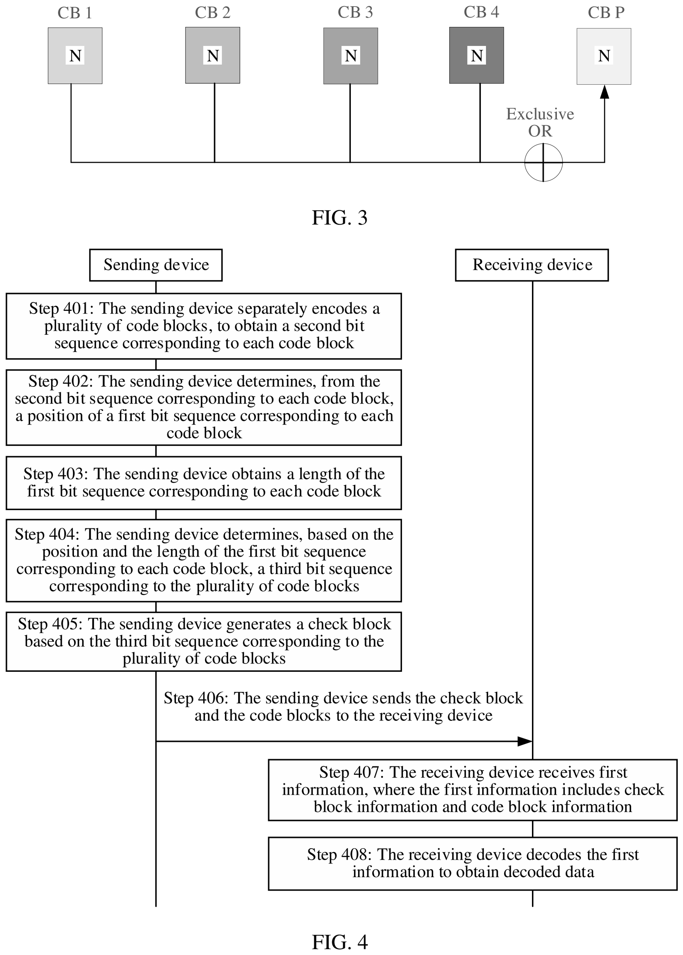

The solution provided for challenge (1) is mainly used currently to enable urLLC to occupy the resource of eMBB, to reduce interference of the urLLC service to the eMBB service. For details, refer to FIG. 3. FIG. 3 is a diagram of a currently used data processing method. As shown in FIG. 3, in addition to sending eMBB code packets (that is, CB 1 to CB 4 in FIG. 3), a base station further sends a check block (that is, CB P in FIG. 3). The check block is obtained by directly performing an exclusive OR operation on the code packets. This brings the following benefit: Even if one eMBB code packet is damaged by urLLC, the code packet can still be recovered by using the check block, so that frequent impact of urLLC on eMBB is reduced.

However, the foregoing method has the following disadvantages:

(a) Scheduling of a urLLC service is not flexible.

Only one CB can be damaged by the urLLC service. If two CBs are damaged, the check block cannot be used for data recovery. In this case, during scheduling of the urLLC service, urLLC needs to be scheduled in a same CB resource as much as possible. This reduces scheduling flexibility of the urLLC service.

(b) A throughput of an eMBB service decreases greatly.

In a case in which only one CB is damaged by urLLC, because the check block received by a receive end is obtained by performing the exclusive OR operation on CB 1 to CB 4, it is equivalent to that retransmission is completely performed on the damaged CB. However, because a urLLC data packet is usually smaller than the CB of eMBB, actually, decoding can be successfully performed without complete retransmission, and pre-transmission of the entire data packet causes an excessively large decrease in the throughput.

For the solution provided for challenge (2), because a HARQ mechanism is to perform retransmission of damaged data to recover data that fails in transmission, a data transmission latency is low.

To resolve the foregoing problems, this application provides a data processing method. For ease of understanding, the following specifically describes the data processing method provided in embodiments of this application with reference to the accompanying drawings and application scenarios. A person of ordinary skill in the art may learn that, as technologies develop and a new scenario emerges, the technical solutions provided in embodiments of this application are also applicable to resolve a similar technical problem.

FIG. 4 is another schematic flowchart of a data processing method according to an embodiment of this application. The data processing method shown in FIG. 4 may be applied to the network device or the terminal device shown in FIG. 1a. The data processing method shown in FIG. 4 is applicable to downlink data transmission, uplink data transmission, and device-to-device (device-to-device, D2D) data transmission. For downlink data transmission, a sending device is a network device, and a corresponding receiving device is a terminal device. For uplink data transmission, a sending device is a terminal device, and a corresponding receiving device is a network device. For D2D data transmission, a sending device is a terminal device, and a corresponding receiving device is also a terminal device. An application scenario is not limited in embodiments of this application.

The following uses the sending device and the receiving device as an example for description. As shown in FIG. 4, the data processing method includes the following step 401 to step 408.

Before step 401, in a possible implementation, the method further includes step 1 and step 2.

Step 1: The sending device obtains indication information.

In this application, for code blocks in a code block group, the sending device obtains the indication information, and determines, from the code block group based on content of the indication information, a plurality of code blocks for generating a check block.

Optionally, the indication information may indicate, in a unit of a single code block, that a service corresponding to one or more code blocks supports another service, in other words, a time-frequency resource used to perform transmission of the service by the sending device is allowed to be occupied by the another service. Correspondingly, the content of the indication information may be in a unit of a single code block, and the plurality of code blocks for generating the check block are determined according to a specific rule.

Optionally, the indication information may alternatively indicate, in a unit of a group, that one or more groups of code blocks support a service. Correspondingly, the content of the indication information may be in a unit of a group, and code blocks in one or more groups are determined as code blocks for generating the check block. Optionally, when a group is used as a unit, a number corresponding to the group may be directly carried in the indication information, or only an expected group size is indicated. After obtaining the information, the sending device may further perform calculation and grouping based on a relationship between a size of the code block group and the expected group size, and determine code blocks in a specified group.

It may be understood that the content of the indication information may be specifically set based on an actual requirement, and a grouping interval may also be set based on an actual situation. These are not limited herein.

Step 2: The sending device determines the plurality of code blocks based on the indication information.

In this application, after obtaining the indication information, the sending device may determine, based on the content of the indication information, the plurality of code blocks for generating the check block.

It should be understood that the content of the indication information may be specifically set based on an actual requirement, and is not limited. An example in which a group is used as a unit and code blocks in one or more groups are determined based on the indication information is used for description.

For example, in a possible implementation, the sending device pre-corresponds code blocks in a code block group to different groups, and each group corresponds to one number. If the content of the indication information includes a specific group number, after receiving the indication information, the sending device determines a plurality of code blocks in a group corresponding to the number as the plurality of code blocks for generating the check block.

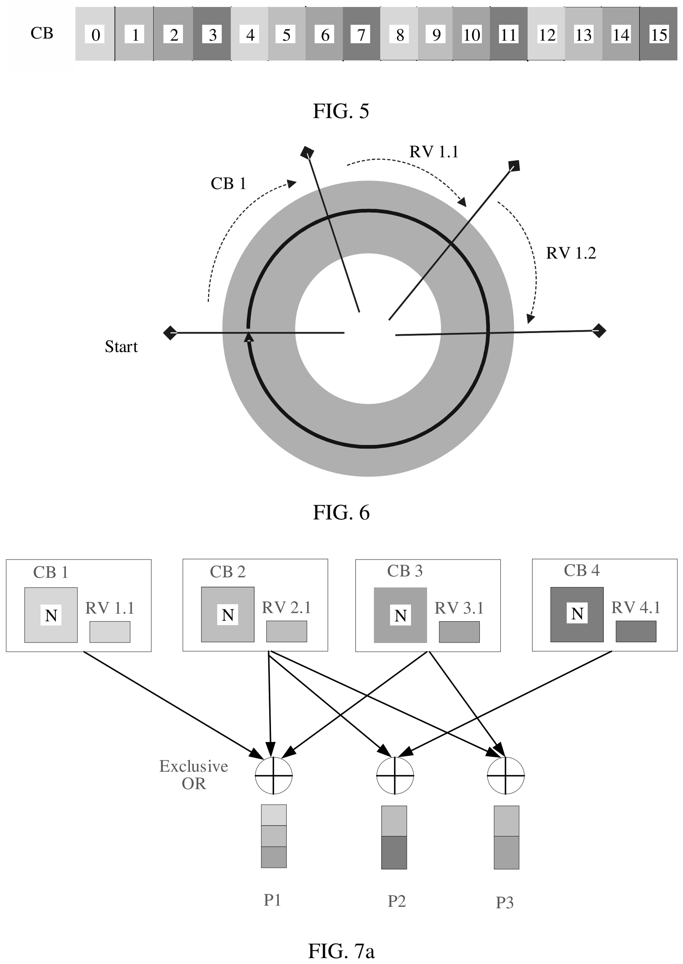

In another possible implementation, the sending device obtains the indication information, where the indication information includes an expected group size S. The sending device obtains a size Z of a code block group, and rounds up a result obtained by dividing the size Z of the code block group by the expected group size S, to obtain a quantity M of groups. After the quantity M of groups is determined, row-column interleaving may be used for grouping, to be specific, an $i^{th}$ group is formed by $\{CBz\,|\,mod(z, S)=i\}$. $z \in \{0, 1, 2, ..., Z-1\}$, and mod() is a modulo function. For details, refer to FIG. 5. FIG. 5 is a diagram of code block grouping according to an embodiment of this application. Assuming that Z is 16, and S is 4, M is 4. Distribution of code blocks obtained through grouping based on row-column interleaving is shown in FIG. 5. Each of {0, 4, 8, 12}, {1, 5, 9, 13}, {2, 6, 10, 14}, and {3, 7, 11, 15} is one group.

It should be noted that grouping is further performed based on a CBG, so that implementation complexity is reduced. In addition, code blocks in the CBG are classified based on whether the code block supports a specific service. This further improves flexibility of service scheduling.

It should be noted that step 1 and step 2 are optional steps in this embodiment of this application. During actual application, the plurality of code blocks for generating the check block may be selected in another manner. Step 1 and step 2 are merely example descriptions of one of the implementations, and are not limited.

Further, step 401 to step 403 are specifically as follows.

Step 401: The sending device separately encodes the plurality of code blocks, to obtain a second bit sequence corresponding to each code block.

In this application, after determining the plurality of code blocks for generating the check block, the sending device separately encodes the plurality of code blocks, to obtain the second bit sequence corresponding to each code block.

In a possible implementation, for each of the plurality of code blocks, the sending device encodes an information bit sequence corresponding to a code block i, and stores an obtained encoded bit sequence in a corresponding buffer. In the buffer corresponding to the code block i, starting from a start position of the buffer, N bits are continuously read and used as a second bit sequence CB i corresponding to the code block i.

Corresponding to an actual service scenario, in a possible implementation, the plurality of code blocks correspond to a first communication mode. A time-frequency resource for transmission in the first communication mode is partially occupied by transmission in a second communication mode, where the first communication mode and the second communication mode correspond to different services or service scenarios.

In this implementation, from a perspective of a service feature, the first communication mode and the second communication mode are indicated and selected by using a field in downlink control information (downlink control information, DCI). That the two communication modes are different specifically means that the two communication modes are different in terms of at least one parameter of a symbol length, a carrier spacing, an MCS table, a code length, a code rate, a modulation order, and the like. From a perspective of a name, the first communication mode may include services such as eMBB and mMTC, and the second communication mode includes a service like urLLC. For ease of understanding, an example in which a time-frequency resource for eMBB transmission is partially occupied by urLLC is used for description below.

In another possible implementation, the sending device only performs transmission in the first communication mode. The plurality of code blocks correspond to the first communication mode.

In this implementation, the first communication mode includes a service like urLLC.

It should be understood that when the sending device transmits only the urLLC service, due to a latency limitation, a urLLC code length is small, and it is generally difficult to meet a reliability requirement of urLLC in a case of a short code. In this case, in a current standard, the reliability requirement is generally met by reducing a code rate and using HARQ retransmission. This results in a low urLLC transmission rate and an increased latency.

In this embodiment of this application, the check block is generated by using a redundancy version sequence of the code block, so that data can still be recovered based on the check block when an error like a transmission failure occurs in a CB of urLLC. This omits a HARQ requirement and further reduces a transmission latency.

Step 402: The sending device determines, from the second bit sequence corresponding to each code block, a position of a first bit sequence corresponding to each code block.

In this application, after obtaining the second bit sequence corresponding to each code block, the sending device may determine, from each code block, the position of the first bit sequence corresponding to the code block. The first bit sequence is a part of the second bit sequence.

In a possible implementation, the first bit sequences respectively corresponding to the plurality of code blocks include the redundancy version sequences respectively corresponding to the code blocks.

In this implementation, for each transmission of a CBG, a redundancy version (Redundancy Version, RV) sequence corresponding to each code block CB in the CBG is a part of a second bit sequence corresponding to the CB.

For example, FIG. 6 is a diagram of position distribution of a first bit sequence and a second bit sequence according to an embodiment of this application. As shown in FIG. 6, in a buffer corresponding to a code block i, starting from a start position of the buffer, N bits are continuously read and used as a second bit sequence CB i corresponding to the code block i. Starting from a position corresponding to CB i, Nsb bits are continued to be continuously read and used as a first bit sequence RV 1.1, and the start point is updated to a bit position corresponding to RV 1.1. In this way, starting from RV 1.1 during next reading, Nsb bits are continued to be read and used as a next first bit sequence RV 1.2. A transmission order in the redundancy version sequence is 0, 1, 2, ..., Nrv-1, and transmission is performed in sequence.

It should be noted that, in a first aspect, the check block is generated based on the redundancy version sequence corresponding to each code block, and encoding does not need to be performed based on each code block, so that when the time-frequency resource for transmission of the eMBB service is partially occupied by the urLLC service, a code block in which an error occurs is recovered through decoding by using the redundancy version sequence, thereby improving error correction performance when assisting in code block recovery. In a second aspect, compared with sending the check block generated directly by encoding each code block, the sending device sends the check block generated based on the redundancy version sequence, so that storage space and a calculation amount are reduced, and decoding performance is improved. In a third aspect, when an error occurs in service data, retransmission of corresponding data does not need to be performed. This improves a throughput of the eMBB service and reduces a latency.

It may be understood that the check block and the redundancy version sequence mentioned in this embodiment of this application are essentially encoded bit sequences, and different encoded bit sequences may be obtained based on different generation manners.

Step 403: The sending device obtains a length of the first bit sequence corresponding to each code block.

In this application, the sending device obtains the length of the first bit sequence corresponding to each code block, to generate the check block based on the position and the length of the first bit sequence. In a possible implementation, the first bit sequences respectively corresponding to the plurality of code blocks include the redundancy version sequences respectively corresponding to the code blocks. In this implementation, as shown in FIG. 6, Nsb is a length of a redundancy version sequence RV 1.1 corresponding to a code block CB 1.

In addition, there are a plurality of implementations for obtaining the length of the first bit sequence. In an optional implementation, in a scenario in which the first communication mode and the second communication mode are multiplexed, the length of the first bit sequence is determined based on at least one of the following: a code length and/or a code rate corresponding to transmission in the first communication mode, and a code length and/or a code rate corresponding to transmission in the second communication mode.

In this implementation, an example in which the first communication mode is eMBB, the second communication mode is urLLC, and a time-frequency resource for eMBB transmission is partially occupied by urLLC is used for description. The sending device calculates the length of the first bit sequence by obtaining a code length $N_{urLLC}$ of urLLC and a code length $N_{eMBB}$ and a code rate R of eMBB. For example, a calculation formula of the length of the first bit sequence may be as follows:

$$\begin{cases} N_{sb} = N, \text{if } R > 0.75 \text{ or if } R \geq 0.5 \text{ and } N_{urLLC} \geq \dfrac{N}{4} & (1) \\ N_{sb} = \dfrac{N_{urLLC}}{2}, \text{otherwise} & (2) \end{cases}$$

It should be understood that a condition (1) corresponds to a case in which the code rate of eMBB is excessively high or the code length of urLLC is excessively large. In this case, the time-frequency resource of eMBB may be fully occupied by urLLC, and recovery in eMBB cannot be implemented. Therefore, when the condition in Formula (1) is not met, the sending device may set the length of the first bit sequence to Formula (2).

In another possible implementation, the sending device only performs transmission in the first communication mode in a scenario.

In this implementation, the first communication mode includes urLLC. In this case, the sending device may determine the length of the first bit sequence based on parameters such as a code length and a code rate of urLLC. Specifically, a condition and specific content of the length of the first bit sequence may be specifically set based on an actual requirement. This is not limited herein.

It should be understood that there is no strict limitation on a time sequence and an execution sequence between step 403 and steps 401 and 402. This is not limited in this application.

Step 404: The sending device determines, based on the position and the length of the first bit sequence corresponding to each code block, a third bit sequence corresponding to the plurality of code blocks.

In this application, for each transmission of a CBG, the sending device determines, based on a start position of the first bit sequence in the second bit sequence in the current transmission and with reference to the length of the first bit sequence, the third bit sequence corresponding to the plurality of code blocks. The third bit sequence may be understood as an encoding result of the first bit sequence corresponding to each code block in the current transmission.

In a possible implementation, an encoding manner includes exclusive OR.

In this implementation, the sending device generates at least one third bit sequence based on an exclusive OR operation performed on the corresponding first bit sequence of each code block. Specifically, the code blocks may be combined in a plurality of manners according to a specific rule to generate a plurality of different third bit sequences.

For example, FIG. 7a is a diagram of generating third bit sequences according to an embodiment of this application. As shown in FIG. 7a, a first bit sequence corresponding to a code block CB i is RV i.1. An exclusive OR operation is performed on RV 1.1, RV 2.1, and RV 3.1 to generate a $1^{st}$ third bit sequence P1, the exclusive OR operation is performed on RV 2.1 and RV 4.1 to generate a $2^{nd}$ third bit sequence P2, and the exclusive OR operation is performed on RV 2.1 and RV 3.1 to generate a $3^{rd}$ third bit sequence P3.

It may be understood that, for ease of description, in the current transmission, a $1^{st}$ position of the redundancy version sequence corresponding to each code block in the second bit sequence is used for description. During actual application, an encoding operation is to be performed based on an actual position of the first bit sequence. This is merely an example for description, and is not limited herein.

It should be noted that the encoding manner of exclusive OR is used in FIG. 7a. During actual application, a specific encoding manner and a specific RV combination used to generate the third bit sequence may be set based on an actual requirement. This is merely an example for description, and is not limited herein.

Step 405: The sending device generates the check block based on the third bit sequence corresponding to the plurality of code blocks.

In this application, after determining, based on the position and the length of the first bit sequence corresponding to each code block, the third bit sequence corresponding to the plurality of code blocks, the sending device may generate the check block based on the at least one third bit sequence corresponding to the plurality of code blocks.

In an optional implementation, a size of the check block is determined based on at least one of the following: a code length and/or a code rate corresponding to transmission in the first communication mode, and a code length and/or a code rate corresponding to transmission in the second communication mode.

In this implementation, when the first communication mode is eMBB, the second communication mode is urLLC, and a time-frequency resource for eMBB transmission is partially occupied by a urLLC service, the size of the check block is related to the code length corresponding to transmission in the first communication mode, and the code length or the code rate corresponding to transmission in the second communication mode.

In an optional implementation, the sending device concatenates third bit sequences corresponding to the plurality of code blocks into the check block.

In this implementation, after obtaining a buffer of the third bit sequence corresponding to the plurality of code blocks, the sending device sends the third bit sequence in the buffer, so that the receiving device obtains the corresponding third bit sequence from the buffer.

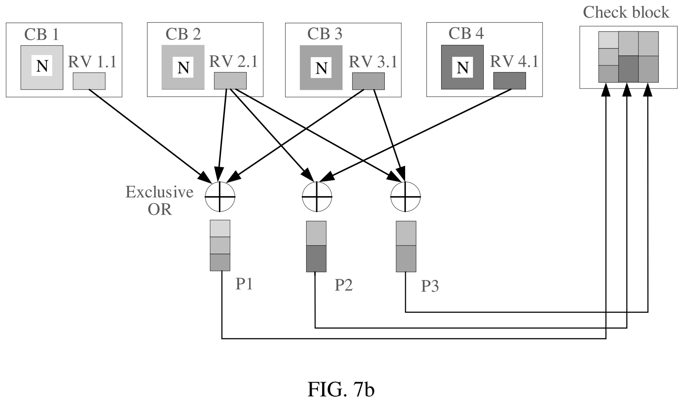

Based on obtaining the third bit sequence by the sending device, further, the sending device may generate the check block based on the third bit sequence. For details, refer to FIG. 7b.

FIG. 7b is a diagram of generating a check block according to an embodiment of this application. As shown in FIG. 7b, a first bit sequence corresponding to a code block CB i is RV i.1. An exclusive OR operation is performed on RV 1.1, RV 2.1, and RV 3.1 to generate a $1^{st}$ third bit sequence P1, the exclusive OR operation is performed on RV 2.1 and RV 4.1 to generate a $2^{nd}$ third bit sequence P2, and the exclusive OR operation is performed on RV 2.1 and RV 3.1 to generate a $3^{rd}$ third bit sequence P3. Further, the sending device concatenates P1, P2, and P3 into a completed check block.

It should be noted that, for ease of description, in the current transmission, a $1^{st}$ position of the redundancy version sequence corresponding to each code block in the second bit sequence is used for description. During actual application, an encoding operation should be performed based on an actual position of the first bit sequence. This is merely an example for description, and is not limited herein.

It should be noted that the current data processing method (as shown in FIG. 3) is applicable only to a scenario in which data is recovered when one CB of eMBB is damaged by urLLC, and flexibility of urLLC scheduling is low. In addition, because a CB of urLLC is usually far smaller than a CB of eMBB, a current solution of retransmission of several CBs of eMBB has low spectral efficiency and a low throughput. However, in this embodiment of this application, in an aspect, when transmitting the eMBB service in a case in which the URLLRC service exists, the sending device determines the first bit sequences from encoded bit sequences corresponding to the plurality of code blocks, and determines the check block based on the first bit sequences. In this way, when an error occurs in at least one code block, erroneous data can be recovered based on the generated check block, so that decoding can still be successful even if a plurality of CBs are damaged by urLLC, thereby improving eMBB service performance and urLLC service flexibility, and improving error correction performance when assisting in code block recovery. In addition, a requirement for performing retransmission of data by using a hybrid automatic repeat request mechanism is omitted, so that a data transmission latency is further reduced. In another aspect, when the sending device transmits only the urLLC service, due to a latency limitation, a urLLC code length is small, and it is generally difficult to meet a reliability requirement of urLLC in a case of a short code. In this case, in a current standard, the reliability requirement is generally met by reducing a code rate and using HARQ retransmission. This results in a low urLLC transmission rate and an increased latency. In this embodiment of this application, the check block is generated by using the redundancy version sequence of the code block, so that data can still be recovered based on the check block when an error like a transmission failure occurs in a CB of urLLC. This omits a HARQ requirement and further reduces a transmission latency.

Step 406: The sending device sends the check block and the code blocks to the receiving device.

In this application, after generating the check block, the sending device sends the encoded and modulated check block and code block to the receiving device.

After the check block is generated based on the code block, a position of the check block in the buffer may be implemented in a plurality of manners. In an optional implementation, the check block is placed after the plurality of code blocks.

In this implementation, for example, as shown in FIG. 5, assuming that a plurality of to-be-sent code blocks of the sending device are {CB 0, CB 4, CB 8, CB 12}, the sending device may place the check block after CB 12, and send the check block and the code blocks.

It should be noted that in this embodiment of this application, only an implementation in which the check block is placed at the end of the plurality of code blocks is specifically described. During actual application, the position of the check block may be set based on an actual requirement, and is not limited.

Step 407: The receiving device receives first information, where the first information includes check block information and code block information.

In this application, the receiving device receives the first information sent by the sending device, to decode the first information. The first information may be understood as a symbol sequence, and is used to recover data.

Step 408: The receiving device decodes the first information to obtain decoded data.

In this application, the receiving device performs demodulation, channel decoding, and source recovery on the first information to output the decoded data.

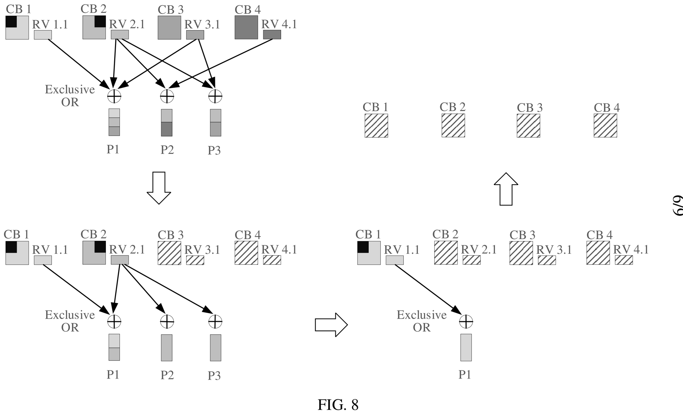

For example, FIG. 8 is a diagram of decoding by a receiving device according to an embodiment of this application. As shown in FIG. 8, time-frequency resources of CB 1 and CB 2 of eMBB are respectively and partially occupied by urLLC, and CB 3 and CB 4 are not occupied. In a first part, after obtaining P1 by performing an exclusive OR operation on CB 1, CB 2, and CB 3, obtaining P2 by performing the exclusive OR operation on CB 2 and CB 4, and obtaining P3 by performing the exclusive OR operation on CB 2 and CB 3, the sending device concatenates P1, P2, and P3 into a check block, and sends the check block to the receiving device. In a second part, based on undamaged CB 3 and undamaged CB 4, the receiving device may obtain a part of CB 2 from P3, obtain a part of CB 2 from P2, and obtain complete CB 2 through decoding. In a third part, after obtaining complete CB 2 and complete CB 3, the receiving device may obtain completed CB 1 through decoding in P1, to finally recover damaged CB 1 and damaged CB 2.

It should be noted that, in FIG. 7a, FIG. 7b, and FIG. 8, the third bit sequences are obtained by using an encoding manner of performing the exclusive OR operation on the code blocks. During actual application, another encoding manner may be used based on an actual requirement. This is not limited herein.

It should be noted that, in this embodiment of this application, the check block is generated by using the redundancy version sequence of the code block, so that data can still be recovered based on the check block when an error like a transmission failure occurs in a CB of urLLC. This improves error correction performance when assisting in code block recovery, and also omits a HARQ requirement, thereby further reducing a transmission latency.

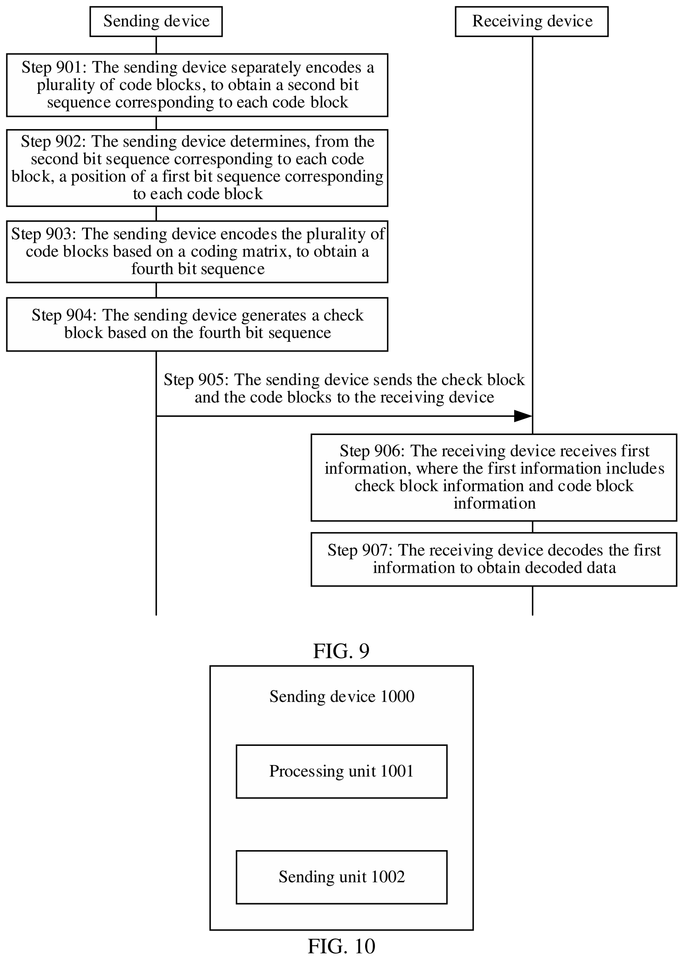

FIG. 9 is another schematic flowchart of a data processing method according to an embodiment of this application. The data processing method shown in FIG. 9 may be applied to the network device or the terminal device shown in FIG. 1a. The data processing method shown in FIG. 9 is applicable to downlink data transmission, uplink data transmission, and device-to-device (device-to-device, D2D) data transmission. For downlink data transmission, a sending device is a network device, and a corresponding receiving device is a terminal device. For uplink data transmission, a sending device is a terminal device, and a corresponding receiving device is a network device. For D2D data transmission, a sending device is a terminal device, and a corresponding receiving device is also a terminal device. An application scenario is not limited in embodiments of this application.

The following uses the sending device and the receiving device as an example for description. As shown in FIG. 9, the data processing method includes the following step 901 to step 907.

Step 901: The sending device separately encodes a plurality of code blocks, to obtain a second bit sequence corresponding to each code block.

Step 902: The sending device determines, from the second bit sequence corresponding to each code block, a position of a first bit sequence corresponding to each code block.

It should be noted that step 901 and step 902 are similar to step 401 and step 402. For a specific implementation and technical details, refer to step 401 and step 402. Details are not described herein again.

Step 903: The sending device encodes the plurality of code blocks based on a coding matrix, to obtain a fourth bit sequence.

In this application, after determining, based on the second bit sequence corresponding to each code block, the position of the first bit sequence corresponding to each code block, the sending device may encode the plurality of code blocks in different combination manners based on the coding matrix, to obtain at least one fourth bit sequence.

It may be understood that the fourth bit sequence in this embodiment of this application and the third bit sequence in the foregoing embodiment have a same meaning, to distinguish between different implementations of generating a check block.

In an optional implementation, the coding matrix may be obtained based on a base graph (base graph, BG).

In this implementation, the BG may generally include m*n matrix elements, and may be represented in a form of a matrix with m rows and n columns, and a value of the matrix element is 0 or 1. An element whose value is 0 is sometimes referred to as a zero element, and an element whose value is 1 is sometimes referred to as a non-zero element. It should be understood that, during actual application, a value of each element in the matrix may be set based on an actual requirement or an experiment, and different matrix forms correspond to different decoding success probabilities. To increase the decoding success probability, an appropriate matrix form may be determined through a pre-test or test.

For example, a form of a coding matrix H may be specifically as follows:

$$H = \begin{matrix} 1 & 1 & 1 & 0 \\ 0 & 1 & 0 & 1 \\ 0 & 1 & 1 & 0 \end{matrix}$$

In the matrix, a code block whose element value is 1 represents a code block that participates in exclusive OR, or may be understood as a code block that supports a urLLC service. In the matrix, a code block whose element value is 0 represents a code block that does not participate in exclusive OR. For example, corresponding to FIG. 7, the first bit sequence corresponding to the code block CB i is RV i.1. It is assumed that in H, each column i corresponds to CB i, and each row j corresponds to Pj. CB i corresponds to each column of a $1^{st}$ row of H, and P1 may be obtained by performing an exclusive OR operation on CB 1, CB 2, and CB 3. Correspondingly, CB i corresponds to each column of a $2^{nd}$ row of H, and P2 may be obtained by performing the exclusive OR operation on elements whose values are 1, that is, CB 2 and CB 4. CB i corresponds to each column of a $3^{rd}$ row of H, and P3 may be obtained by performing the exclusive OR operation on elements whose values are 1, that is, CB 2 and CB 3.

It may be understood that the coding matrix is merely an example form, and the sending device may alternatively encode the plurality of code blocks based on another data form and a connection relationship. This is not limited herein. In addition, when encoding is performed based on the coding matrix, a specific form of the coding matrix may be set based on an actual requirement or an experiment. This is also not limited herein.

It should be noted that, for ease of description, in this embodiment of this application, a $1^{st}$ position of a redundancy version sequence corresponding to each code block in the second bit sequence is used for description. During actual application, an encoding operation is to be performed based on an actual position of the first bit sequence. This is merely an example for description, and is not limited herein.

Step 904: The sending device generates a check block based on the fourth bit sequence.

In this application, after encoding the plurality of code blocks based on the coding matrix to obtain the fourth bit sequence, the sending device may generate the check block based on the fourth bit sequence.

In an optional implementation, a size of the check block is determined based on at least one of the following: a code length and/or a code rate corresponding to transmission in a first communication mode, and a code length and/or a code rate corresponding to transmission in a second communication mode.

In this implementation, when the first communication mode is eMBB, the second communication mode is urLLC, and a time-frequency resource for eMBB transmission is partially occupied by a urLLC service, the size of the check block is related to the code length corresponding to transmission in the first communication mode, and the code length or the code rate corresponding to transmission in the second communication mode.

In an optional implementation, the sending device concatenates fourth bit sequences corresponding to the plurality of code blocks into the check block.

In this implementation, after obtaining a buffer of the fourth bit sequence corresponding to the plurality of code blocks, the sending device sends the fourth bit sequence in the buffer, so that the receiving device obtains the corresponding fourth bit sequence from the buffer.

It may be understood that the fourth bit sequence in this embodiment of this application and the third bit sequence in the foregoing embodiment have a same meaning, to distinguish between different implementations of generating a check block. Correspondingly, step 904 is similar to step 405. For a specific implementation and technical details, refer to step 405. Details are not described herein again.

Step 905: The sending device sends the check block and the code blocks to the receiving device.

Step 906: The receiving device receives first information, where the first information includes check block information and code block information.

Step 907: The receiving device decodes the first information to obtain decoded data.

It should be noted that step 905 to step 907 are similar to step 406 to step 408. For a specific implementation and technical details, refer to step 406 to step 408. Details are not described herein again.

FIG. 10 is a diagram of a structure of a sending device according to an embodiment of this application. The sending device 1000 may be one of the network devices 110a and 110b or may be one of the terminal devices 120a to 120j shown in FIG. 1a, or may be a chip, a chip system, a processor, or the like that supports the network device or the terminal device in implementing the foregoing method. The sending device 1000 includes:

> a processing unit 1001, configured to generate a check block, where the check block is determined based on first bit sequences respectively corresponding to a plurality of code blocks, the first bit sequence is a part of a second bit sequence, and the second bit sequence is an encoded bit sequence of the code block corresponding to the first bit sequence; and
> a sending unit 1002, configured to send the check block and the code blocks.

For detailed descriptions of the processing unit 1001 and the sending unit 1002, refer to the descriptions of step 401 to step 406 in the foregoing embodiment. Details are not described herein again.

It should be noted that, during an actual operation, the processing unit 1001 and the sending unit 1002 may be in a same module of a same sending device, may be in different modules of a same sending device, or may be in different sending devices. Specifically, determining may be performed based on a network range in which the processing unit 1001 and the sending unit 1002 are located, a network division standard, and the like. This is not limited herein.

In a possible implementation, the first bit sequences respectively corresponding to the plurality of code blocks include redundancy version sequences respectively corresponding to the code blocks.

In a possible implementation, the plurality of code blocks correspond to a first communication mode.

In a possible implementation, a time-frequency resource for transmission in the first communication mode is partially occupied by transmission in a second communication mode, where the first communication mode and the second communication mode correspond to different services.

In a possible implementation, a size of the check block is determined based on at least one of the following: a code length and/or a code rate corresponding to transmission in the first communication mode, and a code length and/or a code rate corresponding to transmission in the second communication mode.

In a possible implementation, the first communication mode is enhanced mobile broadband eMBB, and the second communication mode is ultra-reliable and low-latency communications urLLC.

In a possible implementation, before generating the check block, the processing unit is further configured to: obtain indication information, where the indication information indicates the plurality of code blocks that participate in generating the check block, and the plurality of code blocks belong to a first code block group.

In a possible implementation, the processing unit is further configured to:

> obtain positions of the first bit sequences respectively corresponding to the plurality of code blocks, where the position is a position of the first bit sequence in the second bit sequence;
> obtain lengths of the first bit sequences respectively corresponding to the plurality of code blocks;
> determine, based on the positions and the lengths of the first bit sequences respectively corresponding to the plurality of code blocks, a third bit sequence corresponding to the plurality of code blocks; and
> generate the check block based on the third bit sequence corresponding to the plurality of code blocks.

In a possible implementation, the processing unit is further configured to:

encode the plurality of code blocks based on a coding matrix, to obtain a fourth bit sequence; and
generate the check block based on the fourth bit sequence.

In this embodiment, operations performed by the units in the sending device 1000 are similar to those described in the method embodiment shown in FIG. 4, may be used to implement functions of the sending device in the foregoing method embodiments, and can also achieve beneficial effects of the foregoing method embodiments. Details are not described herein again.

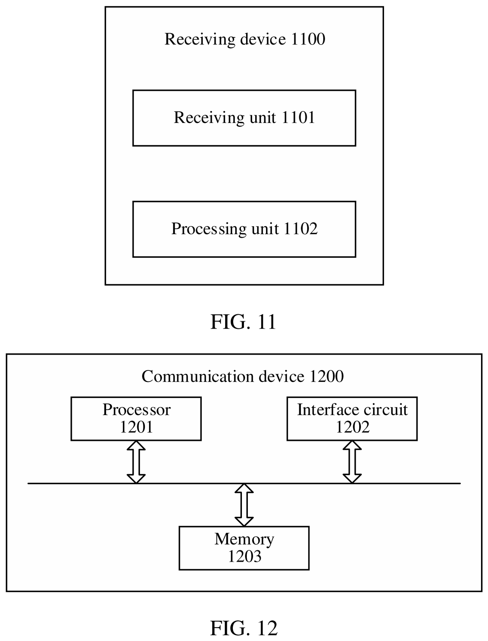

FIG. 11 is a diagram of a structure of a receiving device according to an embodiment of this application. The receiving device 1100 may be one of the network devices 110a and 110b or may be one of the terminal devices 120a to 120j shown in FIG. 1a, or may be a chip, a chip system, a processor, or the like that supports the network device or the terminal device in implementing the foregoing method. The receiving device 1100 includes:

a receiving unit 1101, configured to receive first information, where the first information includes check block information and code block information, a check block is determined based on first bit sequences respectively corresponding to a plurality of code blocks, the first bit sequence is a part of a second bit sequence, and the second bit sequence is an encoded bit sequence of the code block corresponding to the first bit sequence; and
a processing unit 1102, configured to decode the first information to obtain decoded data.

For detailed descriptions of the receiving unit 1101 and the processing unit 1102, refer to the descriptions of step 407 and step 408 in the foregoing embodiment. Details are not described herein again.

It should be noted that, during an actual operation, the receiving unit 1101 and the processing unit 1102 may be in a same module of a same sending device, may be in different modules of a same sending device, or may be in different sending devices. Specifically, determining may be performed based on a network range in which the receiving unit 1101 and the processing unit 1102 are located, a network division standard, and the like. This is not limited herein.

In a possible implementation, the first bit sequences respectively corresponding to the plurality of code blocks include redundancy version sequences corresponding to the code blocks.

In a possible implementation, the plurality of code blocks correspond to a first communication mode.

In a possible implementation, a time-frequency resource for transmission in the first communication mode is partially occupied by transmission in a second communication mode, where the first communication mode and the second communication mode correspond to different services.

In a possible implementation, a size of the check block is determined based on at least one of the following: a code length and/or a code rate corresponding to transmission in the first communication mode, and a code length and/or a code rate corresponding to transmission in the second communication mode.

In a possible implementation, the first communication mode is enhanced mobile broadband eMBB, and the second communication mode is ultra-reliable and low-latency communications urLLC.

In this embodiment, operations performed by the units in the receiving device 1100 are similar to those described in the method embodiment shown in FIG. 4, may be used to implement functions of the receiving device in the foregoing method embodiments, and can also achieve beneficial effects of the foregoing method embodiments. Details are not described herein again.

FIG. 12 is a diagram of a structure of a communication device according to an embodiment of this application. The communication device 1200 may be one of the network devices 110a and 110b or may be one of the terminal devices 120a to 120j shown in FIG. 1a, or may be a chip, a chip system, a processor, or the like that supports the network device or the terminal device in implementing the foregoing method.

The communication device 1200 includes one or more processors 1201 and an interface circuit 1202. The processor 1201 and the interface circuit 1202 are coupled to each other. It may be understood that the interface circuit 1202 may be a transceiver or an input/output interface.

Optionally, the communication device 1200 may include one or more memories 1203, configured to store instructions executed by the processor 1201, store input data required by the processor 1201 to run instructions, or store data generated after the processor 1201 runs instructions.

In another optional design, the processor 1201 may include a transceiver unit configured to implement receiving and sending functions. For example, the transceiver unit may be a transceiver circuit, an interface, or an interface circuit. The transceiver circuit, the interface, or the interface circuit configured to implement the receiving and sending functions may be separated, or may be integrated together. The transceiver circuit, the interface, or the interface circuit may be configured to read and write code/data. Alternatively, the transceiver circuit, the interface, or the interface circuit may be configured for transmission or transfer of a signal.

In another possible design, the communication device 1200 may include a circuit, and the circuit may implement the sending function, the receiving function, or the communication function in the foregoing method embodiments.

When the communication device 1200 is a chip used in a terminal device, the terminal chip implements a function of the terminal device in the foregoing method embodiments. The terminal chip receives information from another module (for example, a radio frequency module or an antenna) in the terminal device, where the information is sent by a network device to the terminal device. Alternatively, the terminal chip sends information to another module (for example, a radio frequency module or an antenna) in the terminal device, where the information is sent by the terminal device to a network device.

When the communication device 1200 is a module used in a network device, the network device module in the network device implements a function of the network device in the foregoing method embodiments. The module in the network device receives information from another module (for example, a radio frequency module or an antenna) in the network device, where the information is sent by a terminal device to the network device. Alternatively, the module in the network device sends information to another module (for example, a radio frequency module or an antenna) in the network device, where the information is sent by the network device to a terminal device. The network device module herein may be a baseband chip of the network device, or may be a DU or another module. The DU herein may be a DU in an open radio access network (open radio access network, O-RAN) architecture.

It may be understood that the processor 1201 in this embodiment of this application may be a central processing unit (Central Processing Unit, CPU), or may be another general-purpose processor, a digital signal processor (Digital Signal Processor, DSP), an application-specific integrated circuit (Application Specific Integrated Circuit, ASIC), a field programmable gate array (Field Programmable Gate Array, FPGA) or another programmable logic device, a transistor logic device, a hardware component, or any combination thereof. The general-purpose processor may be a microprocessor or any regular processor or the like.

The method steps in embodiments of this application may be implemented in hardware, or may be implemented in software instructions that may be executed by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk drive, a portable hard drive, a CD-ROM, or any other form of storage medium well-known in the art. For example, the storage medium is coupled to the processor, so that the processor can read information from the storage medium and write information to the storage medium. The storage medium may alternatively be a component of the processor. The processor and the storage medium may be in an ASIC. In addition, the ASIC may be in a network device or a terminal device. Alternatively, the processor and the storage medium may exist in a network device or a terminal device as discrete components.

The apparatus described in the foregoing embodiments may be a network device or a terminal device. However, the scope of the apparatus described in this application is not limited thereto, and a structure of the apparatus may not be limited by that in FIG. 12. The apparatus may be an independent device, or may be a part of a larger device. For example, the apparatus may be:

(1) an independent integrated circuit IC, a chip, or a chip system or subsystem;
(2) a set including one or more ICs, where optionally, the IC set may further include a storage component configured to store data and/or instructions;
(3) an ASIC, for example, a modem (MSM);
(4) a module that can be embedded in another device;
(5) a receiver, a terminal, an intelligent terminal, a cellular phone, a wireless device, a handheld device, a mobile unit, a vehicle-mounted device, a network device, a cloud device, an artificial intelligence device, a machine device, a home device, a medical device, an industrial device, or the like; or
(6) others.

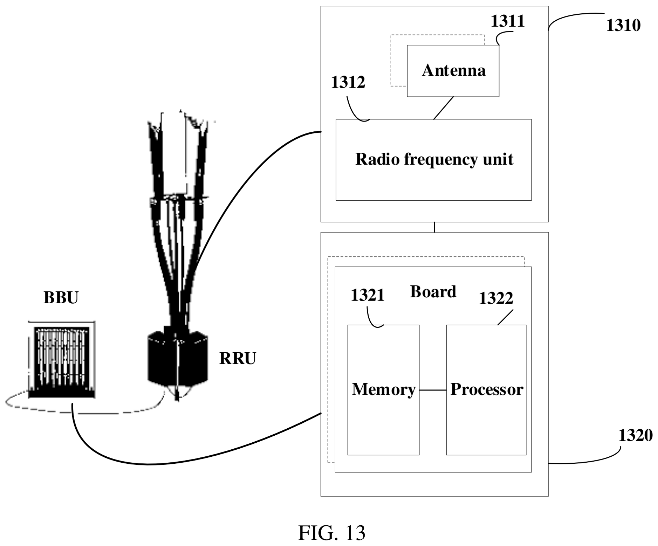

When the communication device in this embodiment of this application is a network device, the communication device may be shown in FIG. 13. FIG. 13 is a diagram of another structure of a communication device according to an embodiment of this application. The communication device 1300 may include one or more radio frequency units, such as a remote radio unit (remote radio unit, RRU) 1310 and one or more baseband units (baseband unit, BBU) (which may also be referred to as a digital unit, digital unit, DU) 1320. The RRU 1310 may be referred to as a transceiver module. The transceiver module may include a sending module and a receiving module, or the transceiver module may be a module that can implement sending and receiving functions. The transceiver module may correspond to the sending unit 1002 in FIG. 10 or the receiving unit 1101 in FIG. 11, in other words, the transceiver module may perform an action of the sending unit 1002 in FIG. 10 or the receiving unit 1101 in FIG. 11. Optionally, the transceiver module may also be referred to as a transceiver machine, a transceiver circuit, a transceiver, or the like, and may include at least one antenna 1311 and a radio frequency unit 1312. The RRU 1310 is mainly configured to: receive and send a radio frequency signal, and perform conversion between a radio frequency signal and a baseband signal. The BBU 1310 is mainly configured to: perform baseband processing, control a base station, and the like. The RRU 1310 and the BBU 1320 may be physically disposed together, or may be physically disposed separately, namely, a distributed base station.

The BBU 1320 is a control center of the base station, may also be referred to as a processing module, and is mainly configured to complete a baseband processing function, such as channel coding, multiplexing, modulation, and spectrum spreading. In addition, the processing module may control an action performed by the processing unit 1001 in FIG. 10 or the processing unit 1102 in FIG. 11. For example, the BBU (the processing module) may be configured to control the base station to perform an operation procedure related to the network device in the foregoing method embodiments.

In an example, the BBU 1320 may include one or more boards. A plurality of boards may jointly support a radio access network (for example, an LTE network) of a single access standard, or may respectively support radio access networks (such as, an LTE network, a 5G network, or another network) of different access standards. The BBU 1320 further includes a memory 1321 and a processor 1322. The memory 1321 is configured to store necessary instructions and data. The processor 1322 is configured to control the base station to perform a necessary action, for example, is configured to control the base station to perform an operation procedure related to the network device in the foregoing method embodiments. The memory 1321 and the processor 1322 may serve one or more boards. In other words, a memory and a processor may be disposed on each board. Alternatively, a plurality of boards may share a same memory and a same processor. In addition, a necessary circuit may be further disposed on each board.

An embodiment of this application further provides a computer-readable medium storing a computer program. When the computer program is executed by a computer, functions of any one of the foregoing method embodiments are implemented.

An embodiment of this application further provides a computer program product. When the computer program product is executed by a computer, functions of any one of the foregoing method embodiments are implemented.

All or some of the foregoing embodiments may be implemented by using software, hardware, firmware, or any combination thereof. When software is used to implement the embodiments, all or a part of the embodiments may be implemented in a form of a computer program product. The computer program product includes one or more computer instructions. When the computer instructions are loaded and executed on a computer, all or some of the procedures or functions according to embodiments of this application are generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk drive, or a magnetic tape), an optical medium (for example, a high-density digital video disc (digital video disc, DVD)), a semiconductor medium (for example, a solid-state drive (solid-state drive, SSD)), or the like.

It may be understood that the system, apparatus, and method described in this application may alternatively be implemented in another manner. For example, the described apparatus embodiments are merely examples. For example, the division of the units is merely the division of logic functions, and may use other division manners during actual implementation. For example, a plurality of units or components may be combined, or may be integrated into another system, or some features may be omitted or not performed. In addition, the displayed or discussed mutual couplings or direct couplings or communication connections may be implemented through some interfaces. The indirect couplings or communication connections between the apparatuses or units may be implemented in electronic, mechanical, or other forms.

Numerals used in embodiments of this application are merely used for differentiation for ease of description, but do not limit the scope of embodiments of this application. Sequence numbers of the foregoing processes do not mean an execution sequence, and the execution sequence of the processes should be determined based on functions and internal logic of the processes.

**Claims**

1. A data processing method, comprising:

   generating a check block, wherein the check block is determined based on first bit sequences respectively corresponding to a plurality of code blocks, the first bit sequence is a part of a second bit sequence, and the second bit sequence is an encoded bit sequence of the code block corresponding to the first bit sequence; and
   sending the check block and the code blocks.

2. The method according to claim 1, wherein the first bit sequences respectively corresponding to the plurality of code blocks comprise redundancy version sequences respectively corresponding to the code blocks.

3. The method according to claim 1 or 2, wherein the plurality of code blocks correspond to a first communication mode.

4. The method according to claim 3, wherein a time-frequency resource for transmission in the first communication mode is partially occupied by transmission in a second communication mode, wherein the first communication mode and the second communication mode correspond to different services.

5. The method according to any one of claims 1 to 4, wherein a size of the check block is determined based on at least one of the following:
a code length and/or a code rate corresponding to transmission in the first communication mode, and a code length and/or a code rate corresponding to transmission in the second communication mode.

6. The method according to claim 4 or 5, wherein the first communication mode is enhanced mobile broadband eMBB, and the second communication mode is ultra-reliable and low-latency communications urLLC.

7. The method according to claim 3, wherein the first communication mode is ultra-reliable and low-latency communications urLLC.

8. The method according to any one of claims 1 to 7, wherein before generating the check block, the method comprises:
obtaining indication information, wherein the indication information indicates the plurality of code blocks that participate in generating the check block, and the plurality of code blocks belong to a first code block group.

9. The method according to any one of claims 1 to 8, wherein generating the check block comprises:

obtaining positions of the first bit sequences respectively corresponding to the plurality of code blocks, wherein the position is a position of the first bit sequence in the second bit sequence;
obtaining lengths of the first bit sequences respectively corresponding to the plurality of code blocks;
determining, based on the positions and the lengths of the first bit sequences respectively corresponding to the plurality of code blocks, a third bit sequence corresponding to the plurality of code blocks; and
generating the check block based on the third bit sequence corresponding to the plurality of code blocks.

10. The method according to any one of claims 1 to 8, wherein generating the check block comprises:

encoding the plurality of code blocks based on a coding matrix, to obtain a fourth bit sequence; and
generating the check block based on the fourth bit sequence.

11. A data processing method, comprising:

receiving first information, wherein the first information comprises check block information and code block information, the check block is determined based on first bit sequences respectively corresponding to a plurality of code blocks, the first bit sequence is a part of a second bit sequence, and the second bit sequence is an encoded bit sequence of the code block corresponding to the first bit sequence; and
decoding the first information to obtain decoded data.

12. The method according to claim 11, wherein the first bit sequences respectively corresponding to the plurality of code blocks comprise redundancy version sequences respectively corresponding to the code blocks.

13. The method according to claim 11 or 12, wherein the plurality of code blocks correspond to a first communication mode.

14. The method according to claim 13, wherein a time-frequency resource for transmission in the first communication mode is partially occupied by transmission in a second communication mode, wherein the first communication mode and the second communication mode correspond to different services.

15. The method according to any one of claims 11 to 14, wherein a size of the check block is determined based on at least one of the following:
a code length and/or a code rate corresponding to transmission in the first communication mode, and a code length and/or a code rate corresponding to transmission in the second communication mode.

16. The method according to claim 14 or 15, wherein the first communication mode is enhanced mobile broadband eMBB, and the second communication mode is ultra-reliable and low-latency communications urLLC.

17. The method according to claim 13, wherein the first communication mode is ultra-reliable and low-latency communications urLLC.

18. A sending device, comprising:

a processing unit, configured to generate a check block, wherein the check block is determined based on first bit sequences respectively corresponding to a plurality of code blocks, the first bit sequence is a part of a second bit sequence, and the second bit sequence is an encoded bit sequence of the code block corresponding to the first bit sequence; and
a sending unit, configured to send the check block and the code blocks.

19. The device according to claim 18, wherein the first bit sequences respectively corresponding to the plurality of code blocks comprise redundancy version sequences corresponding to the code blocks.

20. The device according to claim 18 or 19, wherein the plurality of code blocks correspond to a first communication mode.

21. The device according to claim 20, wherein a time-frequency resource for transmission in the first communication mode is partially occupied by transmission in a second communication mode, wherein the first communication mode and the second communication mode correspond to different services.

22. The device according to any one of claims 18 to 21, wherein a size of the check block is determined based on at least one of the following:
a code length and/or a code rate corresponding to transmission in the first communication mode, and a code length and/or a code rate corresponding to transmission in the second communication mode.

23. The device according to claim 21 or 22, wherein the first communication mode is enhanced mobile broadband eMBB, and the second communication mode is ultra-reliable and low-latency communications urLLC.

24. The device according to claim 20, wherein the first communication mode is ultra-reliable and low-latency communications urLLC.

25. The device according to any one of claims 18 to 24, wherein before generating the check block, the processing unit is further configured to:
obtain indication information, wherein the indication information indicates the plurality of code blocks that participate in generating the check block, and the plurality of code blocks belong to a first code block group.

26. The device according to any one of claims 18 to 25, wherein the processing unit is further configured to:

obtain positions of the first bit sequences respectively corresponding to the plurality of code blocks, wherein the position is a position of the first bit sequence in the second bit sequence;
obtain lengths of the first bit sequences respectively corresponding to the plurality of code blocks;
determine, based on the positions and the lengths of the first bit sequences respectively corresponding to the plurality of code blocks, a third bit sequence corresponding to the plurality of code blocks; and
generate the check block based on the third bit sequence corresponding to the plurality of code blocks.

27. The device according to any one of claims 18 to 25, wherein the processing unit is further configured to:

encode the plurality of code blocks based on a coding matrix, to obtain a fourth bit sequence; and
generate the check block based on the fourth bit sequence.

28. A receiving device, comprising:

a receiving unit, configured to receive first information, wherein the first information comprises check block information and code block information, the check block is determined based on first bit sequences respectively corresponding to a plurality of code blocks, the first bit sequence is a part of a second bit sequence, and the second bit sequence is an encoded bit sequence of the code block corresponding to the first bit sequence; and a processing unit, configured to decode the first information to obtain decoded data.

29. The device according to claim 28, wherein the first bit sequences respectively corresponding to the plurality of code blocks comprise redundancy version sequences respectively corresponding to the code blocks.

30. The device according to claim 28 or 29, wherein the plurality of code blocks correspond to a first communication mode.

31. The device according to claim 30, wherein a time-frequency resource for transmission in the first communication mode is partially occupied by transmission in a second communication mode, wherein the first communication mode and the second communication mode correspond to different services.

32. The device according to any one of claims 28 to 31, wherein a size of the check block is determined based on at least one of the following:
a code length corresponding to transmission in the first communication mode, a code length corresponding to transmission in the second communication mode, or a code rate, and a code length and/or a code rate corresponding to transmission in the first communication mode, and a code length and/or a code rate corresponding to transmission in the second communication mode.

33. The device according to claim 31 or 32, wherein the first communication mode is enhanced mobile broadband eMBB, and the second communication mode is ultra-reliable and low-latency communications urLLC.

34. The device according to claim 30, wherein the first communication mode is ultra-reliable and low-latency communications urLLC.

35. A sending device, comprising a processor and an interface circuit, wherein the interface circuit is configured to: receive a signal from another communication device and transmit the signal to the processor, or send a signal from the processor to another communication device; and the processor is configured to implement the method according to any one of claims 1 to 10 by using a logic circuit or by executing code instructions.

36. A receiving device, comprising a processor and an interface circuit, wherein the interface circuit is configured to: receive a signal from another communication device and transmit the signal to the processor, or send a signal from the processor to another communication device; and the processor is configured to implement the method according to any one of claims 11 to 17 by using a logic circuit or by executing code instructions.

37. A computer-readable storage medium, wherein the storage medium stores a computer program or instructions, and when the computer program or the instructions are executed by a communication device, the method according to any one of claims 1 to 10 or the method according to any one of claims 11 to 17 is implemented.

FIG. 1a

Generate a check block, where the check block is determined based on first bit sequences respectively corresponding to a plurality of code blocks, the first bit sequence is a part of a second bit sequence, and the second bit sequence is an encoded bit sequence of the code block corresponding to the first bit sequence — S1

Send the check block and the code blocks — S2

FIG. 1b

Slot

Allocated time-frequency resource used to perform transmission of eMBB service data

Time-frequency resource preempted by URLLC service data

FIG. 2a

Source → Source encoding → Channel encoding → Modulation

Sink ← Source recovery ← Channel decoding ← Demodulation

FIG. 2b

CB 1    CB 2    CB 3    CB 4    CB P

N    N    N    N    N

Exclusive
OR

FIG. 3

Sending device    Receiving device

Step 401: The sending device separately encodes a plurality of code blocks, to obtain a second bit sequence corresponding to each code block

Step 402: The sending device determines, from the second bit sequence corresponding to each code block, a position of a first bit sequence corresponding to each code block

Step 403: The sending device obtains a length of the first bit sequence corresponding to each code block

Step 404: The sending device determines, based on the position and the length of the first bit sequence corresponding to each code block, a third bit sequence corresponding to the plurality of code blocks

Step 405: The sending device generates a check block based on the third bit sequence corresponding to the plurality of code blocks

Step 406: The sending device sends the check block and the code blocks to the receiving device

Step 407: The receiving device receives first information, where the first information includes check block information and code block information

Step 408: The receiving device decodes the first information to obtain decoded data

FIG. 4

CB | 0 | 1 | 2 | 3 | 4 | 5 | 6 | 7 | 8 | 9 | 10 | 11 | 12 | 13 | 14 | 15

## FIG. 5

## FIG. 6

## FIG. 7a

FIG. 7b

FIG. 8

| Sending device | | Receiving device |
|---|---|---|

Step 901: The sending device separately encodes a plurality of code blocks, to obtain a second bit sequence corresponding to each code block

Step 902: The sending device determines, from the second bit sequence corresponding to each code block, a position of a first bit sequence corresponding to each code block

Step 903: The sending device encodes the plurality of code blocks based on a coding matrix, to obtain a fourth bit sequence

Step 904: The sending device generates a check block based on the fourth bit sequence

Step 905: The sending device sends the check block and the code blocks to the receiving device

Step 906: The receiving device receives first information, where the first information includes check block information and code block information

Step 907: The receiving device decodes the first information to obtain decoded data

FIG. 9

Sending device 1000

Processing unit 1001

Sending unit 1002

FIG. 10

Receiving device 1100

Receiving unit 1101

Processing unit 1102

FIG. 11

Communication device 1200

Processor
1201

Interface circuit
1202

Memory
1203

FIG. 12

**1311** **1310**

**1312** **Antenna**

**Radio frequency unit**

**BBU**

**RRU**

**Board**

**1321** **1322**

**Memory** — **Processor**

**1320**

FIG. 13

**EP 4 686 125 A1**

## INTERNATIONAL SEARCH REPORT

| International application No. |
| --- |
| **PCT/CN2023/085713** |

### A. CLASSIFICATION OF SUBJECT MATTER

H04L1/22(2006.01)i; H03M13/25(2006.01)i

According to International Patent Classification (IPC) or to both national classification and IPC

### B. FIELDS SEARCHED

Minimum documentation searched (classification system followed by classification symbols)

IPC: H04L H03M

Documentation searched other than minimum documentation to the extent that such documents are included in the fields searched

Electronic data base consulted during the international search (name of data base and, where practicable, search terms used)

CNABS; CNTXT; VEN; EPTXT; USTXT; WOTXT; CNKI; 3GPP: 冗余版本, 编码块, 序列, 校验, CB, code block, RV, redundancy version, sequence, check

### C. DOCUMENTS CONSIDERED TO BE RELEVANT

| Category* | Citation of document, with indication, where appropriate, of the relevant passages | Relevant to claim No. |
| --- | --- | --- |
| A | CN 113660056 A (HUAWEI TECHNOLOGIES CO., LTD.) 16 November 2021 (2021-11-16) description, paragraphs [0119]-[0418], and figures 1-12 | 1-37 |
| A | CN 108023675 A (HUAWEI TECHNOLOGIES CO., LTD.) 11 May 2018 (2018-05-11) description, paragraphs [0067]-[0197], and figures 1-16 | 1-37 |
| A | CN 101765992 A (SAMSUNG ELECTRONICS CO., LTD.) 30 June 2010 (2010-06-30) entire document | 1-37 |
| A | CN 110268656 A (PANASONIC INTELLECTUAL PROPERTY CORP. OF AMERICA) 20 September 2019 (2019-09-20) entire document | 1-37 |
| A | WO 2021237398 A1 (QUALCOMM INC. et al.) 02 December 2021 (2021-12-02) entire document | 1-37 |

| ☐ Further documents are listed in the continuation of Box C. | ☑ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **07 December 2023** | **11 December 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

| INTERNATIONAL SEARCH REPORT Information on patent family members | | | | International application No. PCT/CN2023/085713 | | | |
|---|---|---|---|---|---|---|---|

| Patent document cited in search report | | | Publication date (day/month/year) | Patent family member(s) | | | Publication date (day/month/year) |
|---|---|---|---|---|---|---|---|
| CN | 113660056 | A | 16 November 2021 | None | | | |
| CN | 108023675 | A | 11 May 2018 | None | | | |
| CN | 101765992 | A | 30 June 2010 | EP | 2040407 | A2 | 25 March 2009 |
| | | | | EP | 2040407 | A3 | 23 January 2013 |
| | | | | JP | 2013118703 | A | 13 June 2013 |
| | | | | KR | 20100033407 | A | 29 March 2010 |
| | | | | RU | 2426246 | C1 | 10 August 2011 |
| | | | | JP | 2015065699 | A | 09 April 2015 |
| | | | | KR | 20150091444 | A | 11 August 2015 |
| | | | | US | 2009028129 | A1 | 29 January 2009 |
| | | | | US | 8189559 | B2 | 29 May 2012 |
| | | | | AU | 2008279907 | A1 | 29 January 2009 |
| | | | | AU | 2008279907 | B2 | 03 November 2011 |
| | | | | EP | 2890036 | A1 | 01 July 2015 |
| | | | | CA | 2692820 | A1 | 29 January 2009 |
| | | | | CA | 2692820 | C | 13 May 2014 |
| | | | | WO | 2009014374 | A1 | 29 January 2009 |
| | | | | JP | 2010534025 | A | 28 October 2010 |
| CN | 110268656 | A | 20 September 2019 | JP | 2020512717 | A | 23 April 2020 |
| | | | | JP | 6923660 | B2 | 25 August 2021 |
| | | | | WO | 2018170840 | A1 | 27 September 2018 |
| | | | | US | 2019363833 | A1 | 28 November 2019 |
| | | | | US | 10892860 | B2 | 12 January 2021 |
| WO | 2021237398 | A1 | 02 December 2021 | WO | 2021238665 | A1 | 02 December 2021 |

Form PCT/ISA/210 (patent family annex) (July 2022)